# EUROPÄISCHE PATENTSCHRIFT

(11) **EP 2 694 921 B1**
(45) Veröffentlichungstag und Bekanntmachung des Hinweises auf die Patenterteilung: **13.07.2016**
(21) Anmeldenummer: 12716308.7
(22) Anmeldetag: 05.04.2012
(51) Int. Cl.: H03M 3/00, G01D 5/20, H03M 1/64

(54) **VORRICHTUNG ZUM BESTIMMEN EINES ROTORWINKELS EINER ROTIERENDEN WELLE**
DEVICE FOR DETERMINING A ROTOR ANGLE OF A ROTATING SHAFT
DISPOSITIF DESTINÉ À DÉTERMINER UN ANGLE DE ROTOR D'UN ARBRE ROTATIF

(30) Priorität: 07.04.2011 DE 102011006935
(43) Veröffentlichungstag der Anmeldung: 12.02.2014
(73) Patentinhaber: Lenze Automation GmbH, 31855 Aerzen (DE)
(72) Erfinder: DÜSTERBERG, Dirk, 31860 Emmerthal (DE)
(74) Vertreter: Patentanwälte Ruff, Wilhelm, Beier, Dauster & Partner mbB
(86) Internationale Anmeldenummer: PCT/EP2012/056336
(87) Internationale Veröffentlichungsnummer: WO 2012/136795

(56) Entgegenhaltungen:
- EP-A1- 1 324 008
- DE-A1- 10 208 915
- DE-A1-102005 005 024
- DE-A1-102006 059 258
- US-A- 5 162 798
- US-A- 5 485 152
- US-A1- 2002 173 931
- US-A1- 2008 109 189

## Beschreibung

Die Erfindung betrifft eine Vorrichtung zum Bestimmen eines Rotorwinkels einer rotierenden Welle.

Aus der DE 10 2007 029 362 A1 ist eine Vorrichtung zum Bestimmen eines Rotorwinkels einer rotierenden Welle in Form eines Resolvers bekannt, die aufweist: eine erste Statorwicklung, eine zweite Statorwicklung, deren Wicklungsachse zur Wicklungsachse der ersten Statorwicklung in einem rechten Winkel steht, eine Rotorwicklung, die mit der rotierenden Welle drehfest verbunden ist, Mittel zum Beaufschlagen der Rotorwicklung mit einem Trägersignal derart, dass in der ersten und der zweiten Statorwicklung jeweils ein Signal induziert wird, dessen Frequenz mit der Trägersignalfrequenz übereinstimmt und dessen Amplitude mit dem Rotorwinkel moduliert ist, einen ersten Analog-Digital-Wandler, der das in der ersten Statorwicklung induzierte Signal in einen ersten digitalisierten Wert wandelt, einen zweiten Analog-Digital-Wandler, der das in der zweiten Statorwicklung induzierte Signal in einen zweiten digitalisierten Wert wandelt, und eine Auswerteeinrichtung, die auf Basis des ersten und des zweiten digitalisierten Werts den Rotorwinkel bestimmt, wobei der erste Analog-Digital-Wandler und der zweite Analog-Digital-Wandler jeweils einen Sigma-Delta-Modulator, der in Abhängigkeit von dem in der entsprechenden Statorwicklung induzierten Signal einen seriellen Bitstrom mit einer vorgegebenen Bitwiederholfrequenz ausgibt, und einen digitalen Demodulator umfassen. Der digitale Demodulator dient dazu, eine Demodulation des von dem Sigma-Delta-Modulator ausgegebenen seriellen Bitstroms durchzuführen, indem der serielle Bitstrom mittels eines XOR-Gatters mit einem Binärsignal bzw. einem Rechtecksignal XOR-kodiert wird, wobei das Rechtecksignal mit einem Vorzeichen der Erregerspannung korrespondiert.

Der vom Sigma-Delta-Modulator ausgegebene serielle Bitstrom weist prinzipbedingt hochfrequente Rauschanteile auf. Da das zum Mischen verwendete Rechtecksignal Oberwellen d.h. Frequenzanteile bei Vielfachen der Trägerfrequenz aufweist, ist in einem Mischerausgangssignal aufgrund des Mischvorgangs des seriellen Bitstroms mit dem Rechtecksignal ein Teil der hochfrequenten Rauschanteile in einen niederfrequenten Frequenzbereich verschoben, der zum Bestimmen des Rotorwinkels ausgewertet wird. Dies kann zu Ungenauigkeiten beim Bestimmen des Rotorwinkels führen.

Die DE 10 2005 005 024 A1 zeigt eine Resolveranordnung mit einem Sigma-Delta-Modulator, dessen ausgegebener Bitstrom zunächst bitratenreduziert und anschließend synchron demoduliert wird.

Die US 2008/0109189 A1 zeigt ein Signalverarbeitungssystem und ein zugehöriges Verfahren, bei dem ein Bitstrom eines Sigma-Delta-Modulators ebenfalls bitratenreduziert und anschließend demoduliert wird.

Der Erfindung liegt die Aufgabe zugrunde, eine Vorrichtung zum Bestimmen eines Rotorwinkels einer rotierenden Welle zur Verfügung zu stellen, die ausgehend von der in der DE 10 2007 029 362 A1 beschriebenen Vorrichtung eine möglichst zuverlässiges Bestimmen des Rotorwinkels ermöglicht.

Die Erfindung löst dies Aufgabe durch eine Vorrichtung nach Anspruch 1. Bevorzugte Ausführungsformen sind Gegenstand der Unteransprüche, die hiermit zum Inhalt der Beschreibung gemacht werden.

Die Vorrichtung bzw. der Resolver zum Bestimmen eines Rotorwinkels einer rotierenden Welle bzw. zum Bestimmen eines Drehwinkels eines Rotors relativ zu einem Stator umfasst herkömmlich eine erste Statorwicklung, eine zweite Statorwicklung, deren Wicklungsachse zur Wicklungsachse der ersten Statorwicklung in einem rechten Winkel steht, eine Rotorwicklung, die mit der rotierenden Welle drehfest verbunden ist, Mittel zum Beaufschlagen der Rotorwicklung mit einem Trägersignal mit einer Trägersignalfrequenz derart, dass in der ersten und der zweiten Statorwicklung ein Signal induziert wird, dessen Frequenz mit der Trägersignalfrequenz übereinstimmt und dessen Amplitude mit dem Rotorwinkel moduliert ist, einen ersten Analog-Digital-Wandler, der das in der ersten Statorwicklung induzierte Signal in einen ersten digitalisierten Wert wandelt, einen zweiten Analog-Digital-Wandler, der das in der zweiten Statorwicklung induzierte Signal in einen zweiten digitalisierten Wert wandelt, und eine Auswerteeinrichtung, die auf Basis des ersten und des zweiten digitalisierten Werts den Rotorwinkel bestimmt, wobei der erste Analog-Digital-Wandler und der zweite Analog-Digital-Wandler jeweils einen Sigma-Delta-Modulator, der in Abhängigkeit von dem in der entsprechenden Statorwicklung induzierten Signal einen seriellen Bitstrom mit einer vorgegebenen Bitwiederholfrequenz ausgibt, und einen digitalen Synchrondemodulator umfassen.

Der digitale Demodulator ist dazu ausgebildet, eine Demodulation des von dem Sigma-Delta-Modulator ausgegebenen seriellen Bitstroms oder von aus dem seriellen Bitstrom abgeleiteten Bitstrom-Mehrbit-Datenworten durchzuführen, indem der serielle Bitstrom bzw. die Bitstrom-Mehrbit-Datenworte mit der Bitwiederholfrequenz mit Mischer-Mehrbit-Datenworten, beispielsweise mit 12 Bit oder 14 Bit DatenwortBreite, gemischt bzw. multipliziert werden, wobei die Mischer-Mehrbit-Datenworte einem sinusförmigen Signal mit der Trägersignalfrequenz in digitaler Darstellung entsprechen. Die Mischer-Mehrbit-Datenworte können einem ideal sinusförmigen Signal mit der Trägersignalfrequenz in digitaler Darstellung entsprechen.

Die Mischer-Mehrbit-Datenworte können beispielsweise dargestellt werden als MW = sin (2πfₑnTₐ), mit n = 0, 1, 2, ..., ∞, wobei fₑ die Trägersignalfrequenz und Tₐ eine Abtastzeit bezeichnen, wobei die Abtastzeit Tₐ gleich dem Kehrwert der Bitwiederholfrequenz ist. Da das zum Mischen verwendete, im Wesentlichen sinusförmige Signal bzw. dessen abgetastete, digitalisierte Darstellung bei geeignet hoher Abtastfrequenz bzw. Bitwiederholfrequenz im interessierenden Frequenzbereich verglichen mit einem Rechtecksignal im Wesentlichen keine störenden Frequenzanteile bzw. Oberwellen aufweist, werden im Mischprodukt störende Anteile deutlich reduziert, wodurch die Genauigkeit beim Bestimmen des Rotorwinkels erhöht werden kann.

In einer Weiterbildung umfasst der digitale Demodulator einen Funktionsgenerator zum Erzeugen der Mischer-Mehrbit-Datenworte und einen Multiplexer mit einem Steuereingang, einem ersten und einem zweiten Signaleingang und einem Signalausgang, wobei in Abhängigkeit von einem Zustand eines am Steuereingang anstehenden Signals entweder der erste Signaleingang oder der zweite Signaleingang mit dem Signalausgang verbunden ist, der erste Signaleingang mit den Mischer-Mehrbit-Datenworten beaufschlagt ist, der zweite Signaleingang mit vorzeicheninvertierten bzw. negierten Mischer-Mehrbit-Datenworten beaufschlagt ist und der Steuereingang mit dem vom Sigma-Delta-Modulator ausgegebenen seriellen Bitstrom beaufschlagt ist.

In einer Weiterbildung ist ein erstes Dezimierungsfilter vorgesehen, das mit dem Ausgang des Multiplexers verbunden ist. Bevorzugt ist das erste Dezimierungsfilter ein sinc-Filter.

In einer Weiterbildung ist ein zweites Dezimierungsfilter vorgesehen, das mit dem Ausgang des ersten Dezimierungsfilters verbunden ist. Bevorzugt ist das zweite Dezimierungsfilter ein Integrator, wobei an einem Ausgang des zweiten Dezimierungsfilters der digitalisierte Wert ansteht.

Die Erfindung wird nachfolgend unter Bezugnahme auf die Zeichnungen beschrieben. Hierbei zeigt schematisch:
- Fig. 1: eine Vorrichtung zum Bestimmen eines Rotorwinkels einer rotierenden Welle in Form eines Resolvers und
- Fig. 2: einen Analog-Digital-Wandler der in Fig. 1 gezeigten Vorrichtung.

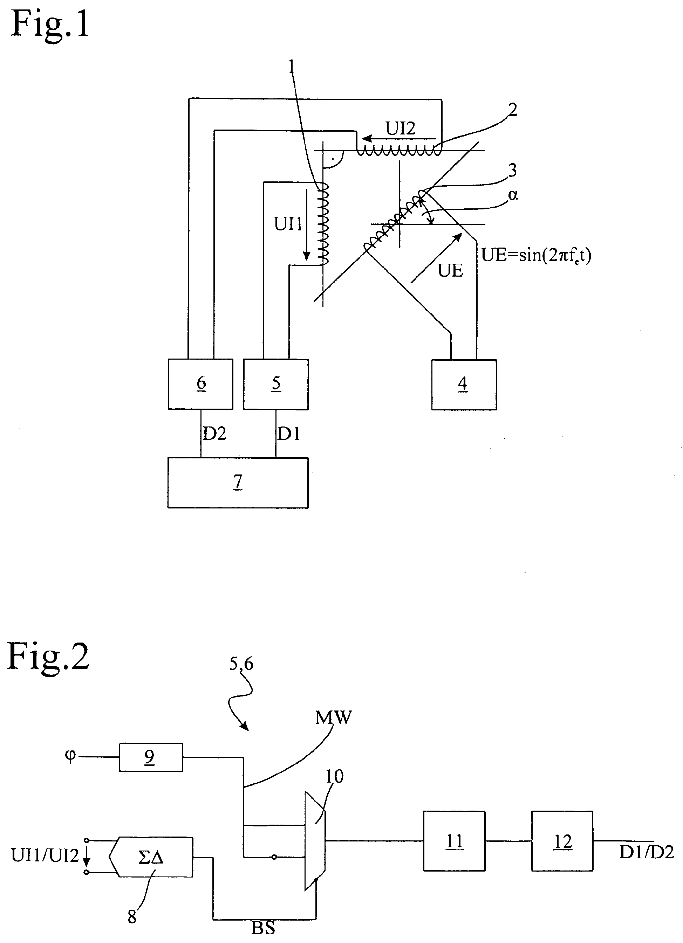

Fig. 1 zeigt eine Vorrichtung zum Bestimmen eines Rotorwinkels einer rotierenden Welle in Form eines Resolvers, wie sie beispielsweise mit Ausnahme der darin enthaltenen Analog-Digital-Wandler auch in der DE 10 2007 029 362 A1 gezeigt ist.

Die Vorrichtung bzw. der Resolver zum Bestimmen eines Rotorwinkels α einer nicht dargestellten, rotierenden Welle umfasst eine erste Statorwicklung 1, eine zweite Statorwicklung 2, deren Wicklungsachse zur Wicklungsachse der ersten Statorwicklung 1 in einem rechten Winkel steht, eine Rotorwicklung 3, die mit der rotierenden Welle drehfest verbunden ist, Mittel 4, beispielsweise einen Funktionsgenerator, zum Beaufschlagen der Rotorwicklung 3 mit einem sinusförmigen Trägersignal UE = sin(2πfₑt) derart, dass in der ersten bzw. der zweiten Statorwicklung 1 bzw. 2 ein Signal UI1 bzw. UI2 induziert wird, dessen Frequenz mit der Trägersignalfrequenz fe übereinstimmt und dessen Amplitude mit dem Rotorwinkel α in der Form sinα bzw. cosα moduliert ist, einen ersten Analog-Digital-Wandler 5, der das in der ersten Statorwicklung 1 induzierte Signal UI1 in einen ersten digitalisierten Wert D1 wandelt, einen zweiten Analog-Digital-Wandler 6, der das in der zweiten Statorwicklung 2 induzierte Signal UI2 in einen zweiten digitalisierten Wert D2 wandelt, und eine Auswerteeinrichtung 7, die auf Basis des ersten und des zweiten digitalisierten Werts D1 und D2 den Rotorwinkel α bestimmt. Zur Funktionsweise sei insoweit auch auf die DE 10 2007 029 362 A1 verwiesen, um unnötige Wiederholungen zu vermeiden.

Fig. 2 zeigt den inneren Aufbau der in Fig. 1 gezeigten Analog-Digital-Wandler 5 und 6 im Detail. Die Analog-Digital-Wandler 5 und 6 umfassen jeweils einen Sigma-Delta-Modulator 8, der in Abhängigkeit von dem in der entsprechenden Statorwicklung 1 bzw. 2 induzierten Signal UI1 bzw. UI2 einen seriellen Bitstrom BS mit einer vorgegebenen Bitwiederholfrequenz f_{B}, beispielsweise 10 MHz, ausgibt, einen digitalen Demodulator im Form eines Funktionsgenerators 9 und eines Multiplexers 10 bzw. umfassend den Funktionsgenerator 9 und den Multiplexer 10, ein erstes Dezimierungsfilter in Form eines herkömmlichen sinc-Filters 11 geeigneter Ordnung, das mit dem Ausgang des Multiplexers 10 verbunden ist, und ein zweites Dezimierungsfilter in Form eines herkömmlichen Integrators 12, der mit dem Ausgang des ersten Dezimierungsfilters verbunden ist, wobei an einem Ausgang des zweiten Dezimierungsfilters 12 der digitalisierte Wert D1 bzw. D2 ansteht.

Der digitale Demodulator umfassend den Funktionsgenerator 9 und den Multiplexer 10 ist dazu ausgebildet, eine Demodulation des von dem Sigma-Delta-Modulator 8 ausgegebenen seriellen Bitstroms BS durchzuführen, indem der serielle Bitstrom BS mit der Bitwiederholfrequenz f_{B} mit vom Funktionsgenerator 9 erzeugten Mischer-Mehrbit-Datenworten MW gemischt wird, wobei die Mischer-Mehrbit-Datenworte MW einem abgetasteten sinusförmigen Signal mit der Trägersignalfrequenz fₑ in digitaler Darstellung entsprechen und beispielsweise eine Datenwortbreite zwischen 8 Bit und 16 Bit aufweisen können. Die Mischer-Mehrbit-Datenworte MW können beispielsweise dargestellt werden als MW = sin (2πfₑnTₐ), mit n = 0, 1, 2, ...,∞, wobei fₑ die Trägersignalfrequenz und Tₐ eine Abtastzeit bezeichnen, wobei die Abtastzeit Tₐ gleich dem Kehrwert der Bitwiederholfrequenz ist, d.h. es gilt Tₐ = 1/f_{B}.

Der Funktionsgenerator 9 zur Erzeugung der Mischer-Mehrbit-Datenworte MW kann beispielsweise einen Kennlinienspeicher umfassen, der einem diskreten Phasenwert ϕ an einem vorgegebenen Abtastzeitpunkt einen Wert sin(ϕ) zuordnet, wobei der Wert sin(ϕ) dem Multiplexer 10 zugeführt wird.

Der Multiplexer 10 umfasst einen Steuereingang, einen ersten und einen zweiten Signaleingang und einen Signalausgang, wobei in Abhängigkeit von einem Zustand eines am Steuereingang anstehenden Signals entweder der erste Signaleingang oder der zweite Signaleingang mit dem Signalausgang verbunden ist. Der erste Signaleingang ist mit den Mischer-Mehrbit-Datenworten MW beaufschlagt, der zweite Signaleingang ist mit invertierten bzw. negierten Mischer-Mehrbit-Datenworten (-1) * MW beaufschlagt und der Steuereingang ist mit dem vom Sigma-Delta-Modulator 8 ausgegebenen seriellen Bitstrom BS beaufschlagt. Abhängig vom momentanen Bit-Zustand des seriellen Bitstroms BS wird folglich MW oder -MW an den sinc-Filter 11 ausgegeben.

Der sinc-Filter 11 erzeugt herkömmlich ein erstes Zwischenwort, welches durch den Integrator 12 herkömmlich integriert wird, um die digitalisierten Datenworte D1 bzw. D2 mit der erforderlichen Bitanzahl, beispielsweise 16 Bit, und der erforderlichen Frequenz, beispielsweise 4 kHz, zu erzeugen. Der Integrator 12 wird nach dem Erzeugen eines vollständigen Datenworts D1 bzw. D2 wieder zurückgesetzt.

Alternativ zu der gezeigten Ausführungsform kann eine Demodulation auch durch Mischen von aus dem seriellen Bitstrom abgeleiteten Bitstrom-Mehrbit-Datenworten mit den Mischer-Mehrbit-Datenworten mit der Bitwiederholfrequenz erfolgen, wobei hierzu aus dem vom Sigma-Delta-Modulator 8 ausgegebenen seriellen Bitstrom BS zunächst mittels einer geeigneten digitalen Schaltung die Bitstrom-Mehrbit-Datenworte, beispielsweise mit einer Datenwortbreite von 4 Bit bis 16 Bit, mit der vorgegebenen Bitwiederholfrequenz erzeugt werden. Das eigentliche Mischen kann dann durch digitale Multiplikation erfolgen.

Die gezeigten Ausführungsformen können, zumindest teilweise, in einem Field programmable Gate Array (FPGA) integriert sein.

## Patentansprüche

1. Vorrichtung zum Bestimmen eines Rotorwinkels (α) einer rotierenden Welle, umfassend:
- eine erste Statorwicklung (1),
- eine zweite Statorwicklung (2), deren Wicklungsachse zur Wicklungsachse der ersten Statorwicklung in einem rechten Winkel steht,
- eine Rotorwicklung (3), die mit der rotierenden Welle drehfest verbunden ist,
- Mittel (4) zum Beaufschlagen der Rotorwicklung mit einem Trägersignal (UE) derart, dass in der ersten und der zweiten Statorwicklung jeweils ein Signal (UI1, UI2) induziert wird, dessen Frequenz mit der Trägersignalfrequenz (fe) übereinstimmt und dessen Amplitude mit dem Rotorwinkel moduliert ist,
- einen ersten Analog-Digital-Wandler (5), der das in der ersten Statorwicklung induzierte Signal in einen ersten digitalisierten Wert (D1) wandelt,
- einen zweiten Analog-Digital-Wandler (6), der das in der zweiten Statorwicklung induzierte Signal in einen zweiten digitalisierten Wert (D2) wandelt, und
- eine Auswerteeinrichtung (7), die auf Basis des ersten und des zweiten digitalisierten Werts den Rotorwinkel bestimmt,
- wobei der erste Analog-Digital-Wandler und der zweite Analog-Digital-Wandler jeweils umfassen:
- einen Sigma-Delta-Modulator (8), der in Abhängigkeit von dem in der entsprechenden Statorwicklung induzierten Signal einen seriellen Bitstrom (BS) mit einer vorgegebenen Bitwiederholfrequenz ausgibt, und
- einen digitalen Demodulator (9, 10),
**dadurch gekennzeichnet, dass**
- der digitale Demodulator dazu ausgebildet ist, eine Demodulation des von dem Sigma-Delta-Modulator ausgegebenen seriellen Bitstroms oder von aus dem seriellen Bitstrom abgeleiteten Bitstrom-Mehrbit-Datenworten durchzuführen, indem der serielle Bitstrom bzw. die Bitstrom-Mehrbit-Datenworte mit der Bitwiederholfrequenz mit Mischer-Mehrbit-Datenworten (MW) gemischt wird, wobei die Mischer-Mehrbit-Datenworte einem abgetasteten sinusförmigen Signal mit der Trägersignalfrequenz in digitaler Darstellung entsprechen.

2. Vorrichtung nach Anspruch 1, **dadurch gekennzeichnet, dass** der digitale Demodulator umfasst:
- einen Funktionsgenerator (9) zum Erzeugen der Mischer-Mehrbit-Datenworte (MW), und
- einen Multiplexer (10) mit einem Steuereingang, einem ersten und einem zweiten Signaleingang und einem Signalausgang, wobei
- in Abhängigkeit von einem Zustand eines am Steuereingang anstehenden Signals entweder der erste Signaleingang oder der zweite Signaleingang mit dem Signalausgang verbunden ist,
- der erste Signaleingang mit den Mischer-Mehrbit-Datenworten beaufschlagt ist,
- der zweite Signaleingang mit invertierten Mischer-Mehrbit-Datenworten beaufschlagt ist und
- der Steuereingang mit dem vom Sigma-Delta-Modulator ausgegebenen seriellen Bitstrom beaufschlagt ist.

3. Vorrichtung nach Anspruch 2, **gekennzeichnet durch**,
- ein erstes Dezimierungsfilter (11), das mit dem Ausgang des Multiplexers verbunden ist.

4. Vorrichtung nach Anspruch 3, **dadurch gekennzeichnet, dass**,
- das erste Dezimierungsfilter ein sinc-Filter ist.

5. Vorrichtung nach Anspruch 4, **gekennzeichnet durch**,
- ein zweites Dezimierungsfilter (12), das mit dem Ausgang des ersten Dezimierungsfilters verbunden ist.

6. Vorrichtung nach Anspruch 5, **dadurch gekennzeichnet, dass**,
- das zweite Dezimierungsfilter ein Integrator ist, wobei an einem Ausgang des zweiten Dezimierungsfilters der digitalisierte Wert ansteht.

## Claims

1. Device for determining a rotor angle (α) of a rotating shaft, comprising:
- a first stator winding (1),
- a second stator winding (2), the winding axis thereof being at a right angle to the winding axis of the first stator winding,
- a rotor winding (3) connected to the rotating shaft for conjoint rotation,
- means (4) for applying a carrier signal (UE) to the rotor winding such that in each of the first and second stator winding one respective signal (UI1, UI2) is induced, the frequency thereof being consonant with the carrier signal frequency (fe) and the amplitude thereof modulated with the rotor angle,
- a first analog-to-digital converter (5) to convert the signal induced in the first stator winding to a first digitized value (D1),
- a second analog-to-digital converter (6) to convert the signal induced in the second stator winding to a second digitized value (D2), and
- an evaluation device (7) to determine the rotor angle based on the first and the second digitized values,
- the first analog-to-digital converter and the second analog-to-digital converter each comprising:
- a sigma-delta modulator (8) to output a serial bitstream (BS) with a predetermined bit repetition frequency in response to the signal induced in the corresponding stator winding, and
- a digital demodulator (9, 10),
**characterized in that**
- the digital demodulator is configured to perform demodulation of the serial bitstream output by the sigma-delta modulator or of bitstream-multibit-datawords derived from the serial bitstream, **in that** the serial bitstream or the bitstream-multibit-datawords are mixed with mixer-multibit-datawords (MW) at the bit repetition frequency, wherein the mixer-multibit-datawords correspond to a sampled sinusoidal signal having the carrier signal frequency in digital representation.

2. Device according to claim 1, **characterized in that** the digital demodulator comprises:
- a function generator (9) for generating the mixer-multibit-datawords (MW), and
- a multiplexer (10) including a control input, a first and a second signal input and a signal output, wherein
- either the first signal input or the second signal input is connected to the signal output in response to a state of a signal applied to the control input,
- the mixer-multibit-datawords are applied to the first signal input,
- the inverted mixer-multibit-datawords are applied to the second signal input, and
- the serial bitstream output from the sigma-delta modulator is applied to the control input.

3. Device according to claim 2, **characterized by**
- a first decimating filter (11) connected to the output of the multiplexer.

4. Device according to claim 3, **characterized in that**
- the first decimating filter is a sinc filter.

5. Device according to claim 4, **characterized by**
- a second decimating filter (12) connected to the output of the first decimating filter.

6. Device according to claim 5, **characterized in that**
- the second decimating filter is an integrator, wherein the digitized value is output at an output of the second decimating filter.

## Revendications

1. Ensemble de détermination de l'angle (α) du rotor d'un arbre rotatif, l'ensemble comprenant :
un premier enroulement de stator (1),
un deuxième enroulement de stator (2) dont l'axe d'enroulement forme un angle droit par rapport à l'axe d'enroulement du premier enroulement de stator,
un enroulement de rotor (3) raccordé à rotation solidaire à l'arbre rotatif,
des moyens (4) destinés à appliquer sur l'enroulement de rotor un signal porteur (UE) dont la fréquence correspond à la fréquence (fe) du signal porteur et dont l'amplitude est modulée par l'angle du rotor de telle sorte qu'un signal (UI1, UI2) respectif soit induit dans le premier et le deuxième enroulement de stator,
un premier convertisseur analogique-numérique (5) qui convertit en une première valeur numérisée (D1) le signal induit dans le premier enroulement de stator,
un deuxième convertisseur analogique-numérique (6) qui convertit en une deuxième valeur numérisée (D2) le signal induit dans le deuxième enroulement de stator,
un dispositif d'évaluation (7) qui détermine l'angle du rotor sur la base de la première et de la deuxième valeur numérisée,
le premier convertisseur analogique-numérique et le deuxième convertisseur analogique-numérique comprenant chacun :
un modulateur sigma-delta (8) qui délivre un flux de bits série (BS) à une fréquence prédéterminée de répétition de bits en fonction du signal induit dans l'enroulement de stator correspondant et
un démodulateur numérique (9, 10),
**caractérisé en ce que**
l e démodulateur numérique est configuré pour réaliser la démodulation du flux de bits série délivrés par le modulateur sigma-delta ou des mots de données à plusieurs bits du flux de bits dérivés du flux de bits série en mélangeant le flux de bits série ou les mots de données à plusieurs bits du flux de bits à la fréquence de répétition de bits avec des mots de données à plusieurs bits (MW) de mélangeur, les mots de données à plusieurs bits de mélangeur correspondant à une représentation numérique d'un signal sinusoïdal échantillonné à la fréquence du signal porteur.

2. Ensemble selon la revendication 1, **caractérisé en ce que** le démodulateur numérique comprend :
un générateur (9) de fonctions qui forme les mots de données (MW) à plusieurs bits de mélangeur et
un multiplexeur (10) qui présente une entrée de commande, une première et une deuxième entrée de signal et une sortie de signal,
la première entrée de signal ou la deuxième entrée de signal étant raccordées à la sortie de signal en fonction de l'état d'un signal appliqué sur l'entrée de signal,
les mots de données à plusieurs bits de mélangeur étant appliqués sur la première entrée de signal,
les mots de données à plusieurs bits de mélangeur inversés étant appliqués sur la deuxième entrée de signal et
le flux de bits série délivrés par le modulateur sigma-delta étant appliqué sur l'entrée de commande.

3. Ensemble selon la revendication 2, **caractérisé par** un premier filtre de décimation (11) raccordé à la sortie du multiplexeur.

4. Ensemble selon la revendication 3, **caractérisé en ce que** le premier filtre de décimation est un filtre sinc.

5. Ensemble selon la revendication 4, **caractérisé par** un deuxième filtre de décimation (12) raccordé à la sortie du premier filtre de décimation.

6. Ensemble selon la revendication 5, **caractérisé en ce que** le deuxième filtre de décimation est un intégrateur, la valeur numérique apparaissant à une sortie du deuxième filtre de décimation.
